# FASCICULE DE BREVET EUROPEEN

(11) **EP 0 578 530 B1**
(45) Date de publication et mention de la délivrance du brevet: **01.03.2000**
(21) Numéro de dépôt: 93401632.0
(22) Date de dépôt: 25.06.1993
(51) Int. Cl.: G06F 9/44

(54) **Procédé d'initialisation automatique d'un système à microprocesseur, et système correspondant**
Verfahren zur automatischen Initialisierung eines Mikroprozessorsystems und entsprechendes System
Method for automatic initialisation of a microprocessor system and corresponding system

(30) Priorité: 26.06.1992 FR 9207864
(43) Date de publication de la demande: 12.01.1994
(73) Titulaire: ELA MEDICAL, F-92541 Montrouge (FR)
(72) Inventeur: Faisandier, Yves, F-75014 Paris (FR)
(74) Mandataire: Laget, Jean-Loup

(56) Documents cités:
- EP-A- 0 457 940
- EP-A- 0 483 865
- EP-A- 0 489 227

## Description

L'invention concerne un procédé d'initialisation automatique d'un système à microprocesseur et le système correspondant.

Les systèmes à microprocesseur comportent une mémoire morte portant les informations correspondant au programme d'initialisation des divers éléments internes et externes du système. Lors de la mise sous tension du système, ou lors d'un redémarrage à chaud (Reset), le microprocesseur lit sur la mémoire morte les instructions d'initialisation. Si la mémoire morte ne contient pas de données, le microprocesseur est dans l'incapacité de fonctionner correctement.

Une carte électronique contenant un microprocesseur porte donc une mémoire morte pour le chargement du programme d'initialisation. Cette mémoire morte est directement soudée au circuit, ou elle est portée par un support lui-même soudé au circuit. Dans le premier cas, la mémoire morte doit être programmée avant d'être soudée au circuit ; dans le second cas, elle doit être programmée avant d'être placée sur son support.

Dans les systèmes portés, qui sont légers et très denses, comme par exemple les enregistreurs ambulatoires d'électrocardiogrammes ou, plus généralement, de données physiologiques, la disposition d'un support de mémoire présente plusieurs inconvénients : le support alourdit l'ensemble, accroît son coût, et peut être la cause de pannes. Il est donc préférable de s'affranchir du support et de souder directement la mémoire morte au circuit.

Le processus de fabrication, présente alors une phase supplémentaire de programmation et de vérification de la mémoire morte avant le soudage de la mémoire sur le circuit.

Le document EP 0 489 227 décrit un système de stockage de données comportant une mémoire amovible. Ce système comporte un programme d'initialisation stocké de façon permanente dans le microprocesseur lui-même, ou chargé par d'autres moyens qu'à partir de la mémoire amovible.

Il est avantageux de prévoir, pour un système donné, la possibilité de changer de programme de travail. A titre d'exemple, un enregistreur ambulatoire peut voir ses fonctionnalités évoluer dans le temps, ou son type d'enregistrement varier (rythme cardiaque, rythme respiratoire ou pression sanguine, par exemple).

Il est parfois nécessaire, sur le même système, de changer d'enregistrement de signal physiologique : il faut alors changer de programme de travail. A cet effet, on peut utiliser une mémoire morte effaçable électriquement et programmable, connue sous le nom de EEPROM ("Electrically Erasable Programmable Read Only Memory"). Cette mémoire EEPROM est mise à jour par effacement puis enregistrement d'un nouveau programme de travail.

Il est possible d'enregistrer dans cette mémoire EEPROM le programme d'initialisation en plus du programme de travail, mais cette solution est dangereuse. En effet, l'effacement de la mémoire EEPROM peut entraîner la perte du programme d'initialisation et, dans ce cas, le microprocesseur ne peut plus fonctionner correctement. Par raison de sécurité, il est en général prévu une mémoire morte pour le programme d'initialisation, et une mémoire EEPROM pour le programme de travail.

Pour la mémoire morte, il est nécessaire de prévoir, une phase supplémentaire de programmation et de vérification avant soudage sur le circuit.

Un but de la présente invention est d'éviter ces inconvénients en n'utilisant qu'une seule mémoire de type EEPROM tout en conservant la sécurité de fonctionnement liée à la disposition de deux mémoires, dans des systèmes utilisant des cartouches-mémoires amovibles comme mémoire de masse.

La présente invention a pour objet un procédé correspondant à la revendication 1, c'est-à-dire un procédé d'initialisation automatique d'un système à microprocesseur, du type utilisant une mémoire programmable pour l'enregistrement du programme d'initialisation et du programme de travail du système et des cartouches-mémoires amovibles comme mémoire de masse, caractérisé en ce que :
- le programme d'initialisation du système est porté par une cartouche-mémoire amovible,
- à la mise sous tension du système, le démarrage du microprocesseur est commandé par l'action d'une ligne spéciale dont le niveau change d'état lors de la mise en place de la cartouche-mémoire, de sorte que le microprocesseur démarre sur le programme d'initialisation porté par la cartouche-mémoire, la sélection des adresses appelées par le microprocesseur étant dirigée vers la cartouche mémoire, lors de la détection d'une cartouche-mémoire portant des programmes.

Selon une autre caractéristique :
- après démarrage du microprocesseur, le programme d'initialisation porté par la cartouche-mémoire est transféré sur la mémoire programmable initialement vierge.

La présente invention a également pour objet un système correspondant à la revendication 3, c'est-à-dire un système à microprocesseur, utilisant une mémoire programmable pour l'enregistrement du programme d'initialisation et du programme de travail, des cartouches-mémoires amovibles comme mémoire de masse, et un circuit de commande, système caractérisé en ce qu'il comporte une cartouche-mémoire amovible portant le programme d'initialisation du système, et une ligne spéciale susceptible, lorsque son niveau change d'état lors de la mise en place de ladite cartouche-mémoire d'agir sur le circuit de commande pour diriger vers la cartouche-mémoire la sélection des adresses appelées par le microprocesseur, de sorte que le microprocesseur démarre sur le programme d'initialisation porté par la cartouche-mémoire lors de la détection d'une cartouche-mémoire portant des programmes.

Selon d'autres caractéristiques de l'invention :
- la ligne spéciale est reliée à une source de polarisation par l'intermédiaire d'un contact qui est fermé lors de la mise en place de la cartouche-mémoire portant les programmes d'initialisation et de travail ;
- ledit contact est fermé par un élément additionnel prévu sur la cartouche-mémoire.

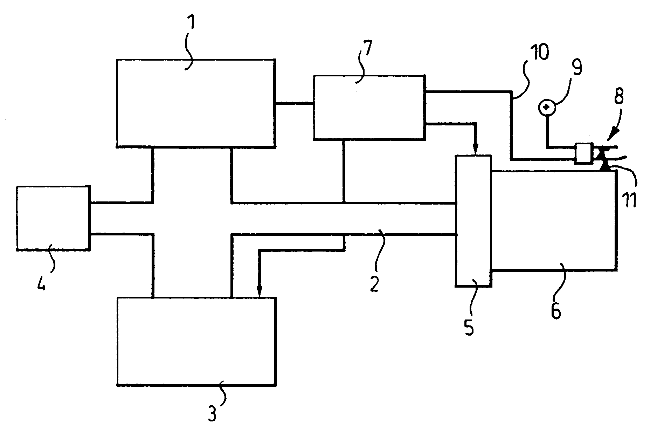

A titre d'exemple, est représenté au dessin annexé un schéma simplifié d'un système à microprocesseur équipé du dispositif selon l'invention.

Sur le dessin, un microprocesseur 1 est relié par un bus 2 de données et adresses, à une mémoire 3 de type EEPROM, à une mémoire vive 4 et à l'interface 5 avec une cartouche-mémoire 6 amovible. Un circuit de commande 7 relié au microprocesseur 1, à la mémoire EEPROM 3 et à l'interface 5, est en outre relié, par une ligne spéciale 10 à une borne d'un contact 8 dont l'autre borne est reliée à une source de polarisation 9 correspondant à un signal de valeur binaire 1. Lorsque le contact 8 est ouvert, la ligne spéciale 10 est au niveau 0, et elle n'a pas d'action sur le circuit de commande 7 : lors de la mise sous tension du système, ou lors d'un redémarrage à chaud, le circuit de commande 7 dirige vers la mémoire EEPROM 3 la sélection des adresses normalement appelées par le microprocesseur 1.

Au contraire, lorsque le contact 8 est fermé, la ligne spéciale 10 passe au niveau 1 et le circuit de commande 7 dirige vers la cartouche-mémoire 6 la sélection des adresses appelées par le microprocesseur 1.

Ainsi, le microprocesseur 1 démarre soit sur la mémoire EEPROM 3 lorsque le contact 8 est ouvert, soit sur la cartouche-mémoire 6, lorsque le contact 8 est fermé.

Lors de sa fabrication, le système est muni d'une mémoire EEPROM 3 vierge, ce qui supprime la phase de programmation et de vérification de la mémoire.

La cartouche-mémoire 6 contient le programme d'initialisation du système et le programme de travail.

Cette cartouche-mémoire 6 est mise en place sur l'interface 5, et le contact 8 est fermé.

A la mise sous tension du système, le microprocesseur 1 exécute le programme d'initialisation inscrit dans la cartouche-mémoire 6, effectue les tests de bon fonctionnement, puis transfère le programme d'initialisation et le programme de travail sur la mémoire EEPROM 3. Le système est alors prêt à exécuter son programme de travail. La cartouche-mémoire 6 peut alors être remplacée par une cartouche-mémoire standard vierge pourle stockage des informations.

Pour effectuer un changement, ou une mise à jour, du programme de travail, l'utilisateur met en place une nouvelle cartouche-mémoire 6 contenant le programme d'initialisation et le nouveau programme de travail, et il ferme le contact 8. A la mise sous tension du système, la mémoire EEPROM 3 est effacée, puis rechargée avec le programme d'initialisation et le nouveau programme de travail.

En cas d'incident pendant le transfert, ou en cours de fonctionnement (coupure de courant, effacement accidentel de la mémoire EEPROM, par exemple), l'utilisateur peut relancer l'opération : le système n'est pas mis en péril par une fausse manoeuvre car le programme d'initialisation et le programme de travail sont toujours dans la cartouche-mémoire 6.

Selon l'invention, la fermeture du contact 8 est assurée automatiquement, lors de la mise en place de la cartouche-mémoire 6 sur l'interface 5, au moyen d'un élément mécanique ou électrique, par exemple. Cet élément additionnel n'est prévu que sur les cartouches-mémoires contant les programmes d'initialisation et de travail. Il n'est pas sur les cartes de stockage de données destinées à être placées sur l'interface 5.

Dans l'exemple de réalisation du dessin, cet élément additionnel est un ergot 11 porté par la cartouche-mémoire 6 et venant fermer un micro-contact 8.

Il peut être constitué par une lamelle métallique fixée à la cartouche-mémoire 6 et venant établir un contact, lorsque la cartouche est en place, entre deux plots solidaires de l'interface 5, de façon à mettre la ligne spéciale 10 au niveau 1.

Une variante consiste à utiliser une ligne de l'interface pour reconnaître une cartouche-mémoire 6 contenant les programmes, mais il faut qu'une ligne de l'interface soit disponible, ce qui n'est pas toujours le cas.

Une autre variante consiste à utiliser le contact de protection d'écriture, habituellement prévu sur les cartouches-mémoires.

D'une façon générale, il est possible d'utiliser tout moyen permettant de détecter la position d'une cartouche-mémoire présentant un repère, par exemple un moyen de détection mécanique, électrique, magnétique ou optoélectronique.

La description précédente a été faite avec référence à une mémoire 3 programmable, de type EEPROM. Il va de soi que cette mémoire programmable peut être d'une autre forme, par exemple une mémoire RAM statique sauvegardée, ou bien qu'elle peut être remplacée par un équivalent technique.

## Revendications

1. Procédé d'initialisation automatique d'un système à microprocesseur, du type utilisant une mémoire programmable pour l'enregistrement du programme d'initialisation et du programme de travail du système et des cartouches-mémoires amovibles comme mémoire de masse, caractérisé en ce que :
- le programme d'initialisation du système est porté par une cartouche-mémoire (6) amovible,
- à la mise sous tension du système, le démarrage du microprocesseur (1) est commandé par l'action d'une ligne spéciale (10) dont le niveau change d'état lors de la mise en place de la cartouche-mémoire (6) de sorte que le microprocesseur (1) démarre sur le programme d'initialisation porté par la cartouche-mémoire (6), la sélection des adresses appelées par le microprocesseur étant dirigée vers la cartouche mémoire (6), lors de la détection d'une cartouche-mémoire (6) portant des programmes.

2. Procédé selon la revendication 1, dans lequel après démarrage du microprocesseur (1), le programme d'initialisation porté par la cartouche-mémoire (6) est transféré sur la mémoire programmable (3) initialement vierge.

3. Système à microprocesseur, utilisant une mémoire programmable pour l'enregistrement du programme d'initialisation et du programme de travail, des cartouches-mémoires amovibles comme mémoire de masse, et un circuit de commande, système caractérisé en ce qu'il comporte une cartouche-mémoire (6) amovible portant le programme d'initialisation du système, et une ligne spéciale (10) susceptible, lorsque son niveau change d'état lors de la mise en place de ladite cartouche-mémoire (6) d'agir sur le circuit de commande (7) pour diriger vers la cartouche-mémoire (6) la sélection des adresses appelées par le microprocesseur (1), de sorte que le microprocesseur (1) démarre sur le programme d'initialisation porté par la cartouche-mémoire (6) lors de la détection d'une cartouche-mémoire (6) portant des programmes.

4. Système selon la revendication 3, dans lequel la ligne spéciale (10) est reliée à une source de polarisation (9) par l'intermédiaire d'un contact (8) qui est fermé lors de la mise en place de la cartouche-mémoire (6) portant les programmes d'initialisation et de travail.

5. Système selon la revendication 4, dans lequel ledit contact (8) est fermé par un élément additionnel (11) prévu sur la cartouche-mémoire.

## Claims

1. A method for automatic initialising of a microprocessor system, of the type using a programmable memory to record the system initialisation program and the system work program, and removable memory cartridges as bulk memory, characterised in that:
- the system initialisation program is borne by a removable memory cartridge (6), and
- upon powering up of the system, the starting of the microprocessor (1) is commanded by the action of a special line (10) whose level changes status when the memory cartridge (6) is being installed so that the microprocessor (1) starts on the initialisation program borne by the memory cartridge (6), the selection of the addresses called by the microprocessor being sent to the memory cartridge (6) when a memory cartridge (6) containing programs is detected.

2. The method as claimed in claim 1, wherein after starting of the microprocessor (1), the initialisation program borne by the memory cartridge (6) is transferred to the initially clean programmable memory (3).

3. A microprocessor system, using a programmable memory to record the initialisation program and work program, removable memory cartridges as bulk memory, and a control circuit, characterised in that it comprises a removable memory cartridge (6) bearing the system initialisation program, and a special line (10) susceptible, when its level changes status when the memory cartridge (6) is being installed, of acting on the control circuit (7) to send the memory cartridge (6) the selection of addresses called by the microprocessor (1), so that the microprocessor (1) starts on the initialisation program borne by the memory cartridge (6) when a memory cartridge containing programs is detected.

4. The system as claimed in claim 3, wherein the special line (10) is connected to a polarisation source (9) by means of a contact (8) which is closed when the memory cartridge (6) containing the initialisation and work programs is being installed.

5. The system as claimed in claim 4, wherein said contact (8) is closed by an additional element (11) provided on the memory cartridge.

## Patentansprüche

1. Automatisches Initialisierungsverfahren eines Mikroprozessorsystems einer einen programmierbaren Speicher zur Registrierung des Initialisierungsprogramms und des Arbeitsprogramms des Systems und auswechselbare Speichereinheiten als Massenspeicher verwendenden Bauart, dadurch gekennzeichnet, dass
- das Initialisierungsprogramm des Systems in einer auswechselbaren Speichereinheit (6) enthalten ist,
- bei Anlegen einer Spannung an das System der Start des Mikroprozessors (1) durch eine spezielle Leitung (10) gesteuert wird, deren Pegel-Zustand sich beim Einsetzen der Speichereinheit (6) so ändert, dass der Mikroprozessor (1) entsprechend dem in der Speichereinheit (6) enthaltenen Intialisierungsprogramm startet, wobei die Auswahl der durch den Mikroprozessor aufgerufenen Adressen zur Speichereinheit (6) geleitet wird, wenn eine Programme enthaltende Speichereinheit (6) erfasst wird.

2. Verfahren nach Anspruch 1, bei dem nach dem Start des Mikroprozessors (1) das in der Speichereinheit (6) enthaltene Initialisierungsprogramm zu dem ursprünglich unbeschriebenen, programmierbaren Speicher (3) übertragen wird.

3. Mikroprozessorsystem, welches einen programmierbaren Speicher zur Registrierung des Initialisierungsprogramms und des Arbeitsprogramms sowie auswechselbare Speichereinheiten als Massenspeicher und eine Steuerschaltung verwendet, wobei das System dadurch gekennzeichnet ist, dass es folgendes umfasst: eine austauschbare Speichereinheit (6), die das Initialisierungsprogramm des Systems enthält, und eine spezielle Leitung (10), die, wenn sich der Zustand ihres Pegels beim Einsetzen der Speichereinheit (6) ändert, geeignet ist, auf die Steuerschaltung (7) einzuwirken, um die Auswahl der durch den Mikroprozessor (1) aufgerufenen Adressen zur Speichereinheit (6) zu leiten, so dass der Mikroprozessor (1) bei der Erfassung einer Programme enthaltenden Speichereinheit (6) entsprechend dem in der Speichereinheit (6) enthaltenen Initialisierungsprogramm startet.

4. System nach Anspruch 3, bei dem die spezielle Leitung (10) mit einer Polarisationsquelle (9) mittels eines Kontakts (8) verbunden ist, der beim Einsetzen der die Initialisierungs- und Arbeitsprogramme enthaltenden Speichereinheit (6) geschlossen wird.

5. System nach Anspruch 4, bei dem der Kontakt (8) durch ein auf der Speichereinheit vorgesehenes, zusätzliches Element (11) geschlossen wird.
